(19) Europäisches Patentamt
European Patent Office
Office européen des brevets

(11) EP 4 727 020 A1

(12) **EUROPEAN PATENT APPLICATION**
published in accordance with Art. 153(4) EPC

(43) Date of publication:
15.04.2026 Bulletin 2026/16

(21) Application number: 24838593.2

(22) Date of filing: 26.06.2024

(51) International Patent Classification (IPC):
*H04B 1/04* (2006.01)

(52) Cooperative Patent Classification (CPC):
H04B 1/036; H04B 1/04; H04B 7/0404;
H04B 7/0408; H04B 7/06

(86) International application number:
PCT/CN2024/101562

(87) International publication number:
WO 2025/011337 (16.01.2025 Gazette 2025/03)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 10.07.2023 CN 202310842681

(71) Applicant: Huawei Technologies Co., Ltd.
Shenzhen, Guangdong 518129 (CN)

(72) Inventors:
• QI, Huali
Shenzhen, Guangdong 518129 (CN)

• PAN, Yongchao
Shenzhen, Guangdong 518129 (CN)
• JIN, Qingguo
Shenzhen, Guangdong 518129 (CN)
• ZHANG, Hongxian
Shenzhen, Guangdong 518129 (CN)
• GONG, Zhengwei
Shenzhen, Guangdong 518129 (CN)

(74) Representative: Goddar, Heinz J.
Boehmert & Boehmert
Anwaltspartnerschaft mbB
Pettenkoferstrasse 22
80336 München (DE)

(54) **POWER SHARING METHOD AND APPARATUS**

(57) This application provides a power sharing method and an apparatus, to implement power sharing between different power amplifiers. The method includes: determining a first required power of a first power amplifier and a second required power of a second power amplifier; and transmitting a first signal on a basis that an output power of the first power amplifier is the first required power, and transmitting a second signal on a basis that an output power of the second power amplifier is the second required power, where the first required power is greater than or equal to a nominal power, the second required power is less than or equal to the nominal power, and a heat dissipation index of the first power amplifier is greater than a heat dissipation index of the second power amplifier, where the nominal power is an average maximum output power of all power amplifiers in a radio frequency unit, the radio frequency unit includes the first power amplifier and the second power amplifier, and the first power amplifier and the second power amplifier correspond to different radio frequency channels.

500

510: Determine a first required power of a first power amplifier and a second required power of a second power amplifier

520: Transmit a first signal on a basis that an output power of the first power amplifier is the first required power, and transmit a second signal on a basis that an output power of the second power amplifier is the second required power, where the first required power is greater than or equal to a nominal power, the second required power is less than or equal to the nominal power, and a heat dissipation index of the first power amplifier is greater than a heat dissipation index of the second power amplifier

FIG. 5

## Description

### TECHNICAL FIELD

This application relates to the communication field, and more specifically, to a power sharing method and an apparatus.

### BACKGROUND

In a multi-antenna system, a quantity of channels of a radio frequency unit increases, and in this case, a quantity of independent power amplifiers in one radio frequency unit increases, and a quantity of frequency bands supported by one power amplifier increases. Further, different power amplifiers have different power requirements, or power requirements of a plurality of frequency bands supported by one power amplifier are different. Therefore, power sharing between a plurality of power amplifiers or power sharing between a plurality of frequency bands in one power amplifier becomes an effective means for improving efficiency of a power amplifier.

Currently, a solution of power sharing between a plurality of frequency bands in one power amplifier implements power sharing inside one power amplifier. To implement power sharing between different power amplifiers, a solution of power sharing between a plurality of power amplifiers based on a bridge needs to be used. In this solution, hardware circuits such as a digital bridge and an analog bridge are added to the radio frequency unit. As a result, an additional insertion loss is introduced, and an additional power loss is increased. In addition, leakage interference between different power amplifiers is prone to occur due to introduction of the digital bridge and the analog bridge.

### SUMMARY

This application provides a power sharing method and an apparatus, to implement power sharing between different power amplifiers.

According to a first aspect, a power sharing method is provided. The method may be performed by a network device or a chip or a chip system on a network device side. The network device includes a radio frequency unit, where the radio frequency unit includes a first power amplifier and a second power amplifier, the first power amplifier and the second power amplifier correspond to different radio frequency channels, and the method includes: determining a first required power of the first power amplifier and a second required power of the second power amplifier; and transmitting a first signal on a basis that an output power of the first power amplifier is the first required power, and transmitting a second signal on a basis that an output power of the second power amplifier is the second required power, where the first required power is greater than or equal to a nominal power, the second required power is less than or equal to the nominal power, and a heat dissipation index of the first power amplifier is greater than a heat dissipation index of the second power amplifier, where the nominal power is an average maximum output power of all power amplifiers in the radio frequency unit.

Based on the foregoing technical solution, the second required power of the second power amplifier is low, and a heat dissipation index when the output power of the second power amplifier is the second required power is redundant relative to a heat dissipation index when the output power of the second power amplifier is the nominal power. However, the first required power of the first power amplifier is high, and a heat dissipation index when the output power of the first power amplifier is the first required power is insufficient relative to a heat dissipation index when the output power of the first power amplifier is the nominal power. The technical solution in embodiments of this application is equivalent to that the first power amplifier "borrows" the heat dissipation index of the second power amplifier, so that it can be ensured that heat dissipation of the entire radio frequency unit is maintained within a safe range. Therefore, in embodiments of this application, heat dissipation indexes are shared between different power amplifiers, so that power sharing between different power amplifiers is equivalently implemented.

With reference to the first aspect, in some implementations of the first aspect, determining the first required power of the first power amplifier and the second required power of the second power amplifier includes: determining the first required power based on a position at which a first antenna subarray corresponding to the first power amplifier is located in an antenna array, where the antenna array is an equally spaced beamforming antenna array; and determining the second required power based on a position at which a second antenna subarray corresponding to the second power amplifier is located in the antenna array. In an equally spaced beamforming antenna array, a required power of a power amplifier connected to an antenna subarray located in a middle column of the antenna array is high, and may be greater than the nominal power; and a required power of a power amplifier connected to an antenna subarray located in a side column of the antenna array is low, and may be less than the nominal power.

With reference to the first aspect, in some implementations of the first aspect, the position at which the first antenna subarray is located in the antenna array is a middle column of the antenna array, and the position at which the second antenna subarray is located in the antenna array is a side column of the antenna array.

With reference to the first aspect, in some implementations of the first aspect, determining the first required power of the first power amplifier and the second required power of the second power amplifier includes: determining the first required power based on a type of the first signal; and determining the second required power based on a type of the second signal. In a heterogeneous signal sending antenna array, a required power of a power amplifier depends on a type of a signal sent by an antenna subarray corresponding to the power amplifier.

With reference to the first aspect, in some implementations of the first aspect, the type of the first signal is a broadcast signal, and the type of the second signal is a unicast signal.

With reference to the first aspect, in some implementations of the first aspect, a clipping threshold corresponding to the first power amplifier is greater than a clipping threshold corresponding to the second power amplifier. This can prevent an error vector magnitude (error vector magnitude, EVM) of an output signal of the first power amplifier from being excessively large, to avoid distortion of the output signal of the first power amplifier.

With reference to the first aspect, in some implementations of the first aspect, a sum of the first required power and the second required power is less than or equal to twice the nominal power. A total required power of the first power amplifier and the second power amplifier can be prevented from being excessively high, to ensure safety of the radio frequency unit.

With reference to the first aspect, in some implementations of the first aspect, the first required power is less than or equal to a first threshold, and the first threshold is a maximum output power of the first power amplifier. The first threshold may also be understood as an allowed maximum output power of the first power amplifier. In this implementation, the first required power of the first power amplifier can be prevented from exceeding the allowed maximum output power of the first power amplifier, to avoid damage to the first power amplifier.

With reference to the first aspect, in some implementations of the first aspect, a sum of a heat dissipation requirement with the output power of the first power amplifier being the first required power and a heat dissipation requirement with the output power of the second power amplifier being the second required power is less than or equal to a second threshold, and the second threshold is a total heat dissipation requirement with the output power of the first power amplifier and the output power of the second power amplifier each being the nominal power.

Based on this possible implementation solution, the sum of the heat dissipation requirement with the output power of the first power amplifier being the first required power and the heat dissipation requirement with the output power of the second power amplifier being the second required power is less than or equal to the second threshold, so that it can be ensured that the heat dissipation of the entire radio frequency unit is maintained within a safe range, to ensure safety of the radio frequency unit.

With reference to the first aspect, in some implementations of the first aspect, the heat dissipation index of the first power amplifier is less than or equal to a third threshold, and the third threshold is actual allowed maximum heat dissipation of the first power amplifier. This can prevent the heat dissipation index of the first power amplifier from being excessively large, to ensure that the heat dissipation of the entire radio frequency unit is maintained within a safe range, so as to ensure safety of the radio frequency unit.

According to a second aspect, a communication apparatus is provided. The apparatus may be used in the network device according to the first aspect, and the apparatus includes a processing unit, a first power amplifier, and a second power amplifier, and the first power amplifier and the second power amplifier correspond to different radio frequency channels; the processing unit is configured to determine a first required power of the first power amplifier and a second required power of the second power amplifier; and the processing unit is further configured to transmit a first signal on a basis that an output power of the first power amplifier is the first required power, and transmit a second signal on a basis that an output power of the second power amplifier is the second required power, where the first required power is greater than or equal to a nominal power, the second required power is less than or equal to the nominal power, and a heat dissipation index of the first power amplifier is greater than a heat dissipation index of the second power amplifier, where the nominal power is an average maximum output power of all power amplifiers in the communication apparatus. In a possible implementation, the communication apparatus may be a radio frequency unit in the network device, and the processing unit includes a power management unit.

With reference to the second aspect, in some implementations of the second aspect, the processing unit is specifically configured to: determine the first required power based on a position at which a first antenna subarray corresponding to the first power amplifier is located in an antenna array, where the antenna array is an equally spaced beamforming antenna array; and determine the second required power based on a position at which a second antenna subarray corresponding to the second power amplifier is located in the antenna array.

With reference to the second aspect, in some implementations of the second aspect, the position at which the first antenna subarray is located in the antenna array is a middle column of the antenna array, and the position at which the second antenna subarray is located in the antenna array is a side column of the antenna array.

With reference to the second aspect, in some implementations of the second aspect, the processing unit is specifically configured to: determine the first required power based on a type of the first signal; and determine the second required power based on a type of the second signal.

With reference to the second aspect, in some implementations of the second aspect, the type of the first signal is a broadcast signal, and the type of the second signal is a unicast signal.

With reference to the second aspect, in some implementations of the second aspect, a clipping threshold corresponding to the first power amplifier is greater than a clipping threshold corresponding to the second power amplifier.

With reference to the second aspect, in some implementations of the second aspect, a sum of the first required power and the second required power is less than or equal to twice the nominal power.

With reference to the second aspect, in some implementations of the second aspect, the first required power is less than or equal to a first threshold, and the first threshold is a maximum output power of the first power amplifier.

With reference to the second aspect, in some implementations of the second aspect, a sum of a heat dissipation requirement with the output power of the first power amplifier being the first required power and a heat dissipation requirement with the output power of the second power amplifier being the second required power is less than or equal to a second threshold, and the second threshold is a total heat dissipation requirement with the output power of the first power amplifier and the output power of the second power amplifier each being the nominal power.

With reference to the second aspect, in some implementations of the second aspect, the heat dissipation index of the first power amplifier is less than or equal to a third threshold, and the third threshold is actual allowed maximum heat dissipation of the first power amplifier.

According to a third aspect, a communication apparatus is provided, including a processor and a memory. The memory is configured to store a computer program. The processor is configured to execute the computer program stored in the memory, so that the communication apparatus performs the method according to any one of the first aspect or the possible implementations of the first aspect.

According to a fourth aspect, a communication apparatus is provided, including a unit configured to perform the method according to any one of the first aspect or the possible implementations of the first aspect.

According to a fifth aspect, a computer-readable storage medium is provided. The computer-readable medium stores a computer program; and when the computer program is run on a computer, the computer is caused to perform the method according to any one of the first aspect or the possible implementations of the first aspect.

According to a sixth aspect, a computer program product including instructions is provided. When the instructions are executed by a computer, a communication apparatus is caused to perform the method according to any one of the first aspect or the possible implementations of the first aspect.

The solutions provided in the second aspect to the sixth aspect are used for implementing or cooperatively implementing the method provided in the first aspect, and therefore can achieve beneficial effects the same as or corresponding to those in the first aspect. Details are not described herein again.

## BRIEF DESCRIPTION OF DRAWINGS

FIG. 1 is a diagram of a structure of a network device according to an embodiment of this application;
FIG. 2 is a diagram of an equally spaced beamforming antenna array;
FIG. 3 is a diagram of a heterogeneous signal sending antenna array;
FIG. 4 is a diagram of connection between a power management unit and a power amplifier;
FIG. 5 is a schematic flowchart of a power sharing method according to an embodiment of this application;
FIG. 6 is a diagram of a first clipping threshold corresponding to a first power amplifier and a second clipping threshold corresponding to a second power amplifier;
FIG. 7 is a block diagram of a communication apparatus according to an embodiment of this application; and
FIG. 8 is a block diagram of another communication apparatus according to an embodiment of this application.

## DESCRIPTION OF EMBODIMENTS

The following describes technical solutions of this application with reference to accompanying drawings.

Embodiments of this application may be applied to various communication systems, for example, a wireless local area network (wireless local area network, WLAN) system, a narrowband internet of things (narrowband internet of things, NB-IoT) system, a global system for mobile communications (global system for mobile communications, GSM), an enhanced data rates for GSM evolution (enhanced data rate for GSM evolution, EDGE) system, a wideband code division multiple access (wideband code division multiple access, WCDMA) system, a code division multiple access 2000 (code division multiple access, CDMA2000) system, a time division-synchronous code division multiple access (time division-synchronous code division multiple access, TD-SCDMA) system, a long term evolution (long term evolution, LTE) system, satellite communication, a 5th generation (5th generation, 5G) system, and three application scenarios of the 5G communication system: enhanced mobile broadband (enhanced mobile broadband, eMBB), ultra-reliable and low-latency communication (ultra-reliable and low-latency communication, URLLC), and massive machine type communication (massive machine type communication, mMTC).

A communication system to which this application is applicable includes one or more transmitters and one or more receivers. Signal transmission between the transmitter and the receiver may be performed by using a radio wave, or may be performed by using transmission media, for example, visible light, a laser, infrared light, and an optical fiber. For example, one of the transmitter and the receiver may be a terminal device, and the other may be a radio access network (radio access network, RAN) node.

The terminal device in embodiments of this application may include various handheld devices, vehicle-mounted devices, wearable devices, or computing devices that have a wireless communication function, or other processing devices connected to a wireless modem. The terminal may be a mobile station (mobile station, MS), a subscriber unit (subscriber unit), a user equipment (user equipment, UE), a cellular phone (cellular phone), a smartphone (smartphone), a wireless data card, a personal digital assistant (personal digital assistant, PDA) computer, a tablet computer, a wireless modem (modem), a handheld device (handset), a laptop computer (laptop computer), a machine type communication (machine type communication, MTC) terminal, or the like. The user equipment includes vehicle user equipment.

In a possible scenario, the RAN node may be a base station (base station), an evolved NodeB (evolved NodeB, eNodeB), an access point (access point, AP), a transmission reception point (transmission reception point, TRP), a next generation NodeB (next generation NodeB, gNB), a next generation base station in a 6th generation (6th generation, 6G) mobile communication system, a base station in a future mobile communication system, an access node in a Wi-Fi system, or the like. The RAN node may be a macro base station, a micro base station or an indoor base station, a relay node or a donor node, or a radio controller in a CRAN scenario. Optionally, the RAN node may alternatively be a server, a wearable device, a vehicle, a vehicle-mounted device, or the like. For example, an access network device in a vehicle-to-everything (vehicle-to-everything, V2X) technology may be a roadside unit (roadside unit, RSU).

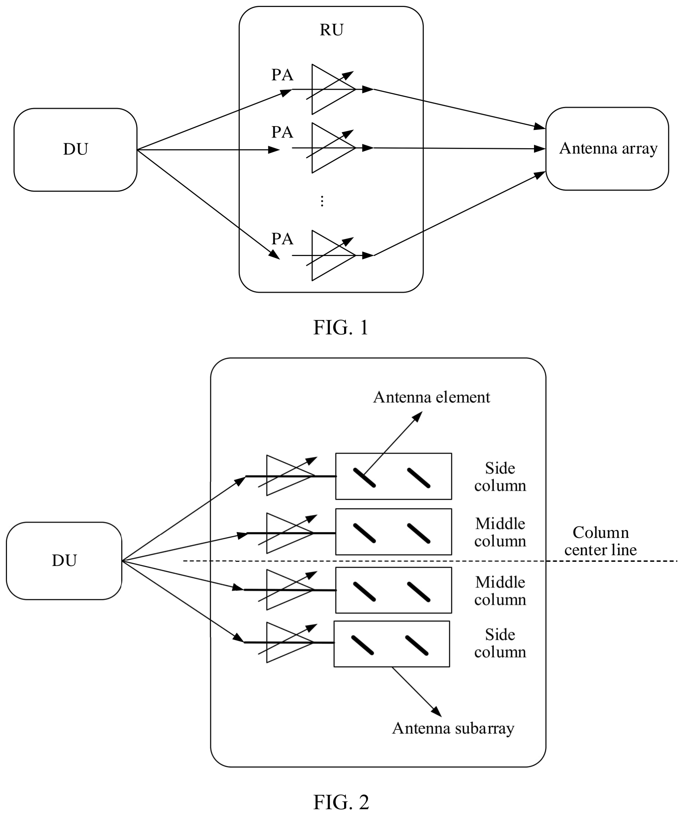

In another possible scenario, a plurality of RAN nodes coordinate to assist the terminal in implementing radio access, and different RAN nodes separately implement some functions of the base station. For example, the RAN node may be a central unit (central unit, CU), a distributed unit (distributed unit, DU), a CU-control plane (control plane, CP), a CU-user plane (user plane, UP), a radio unit (radio unit, RU), or the like. The CU and the DU may be separately arranged, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH). FIG. 1 is a diagram of a structure of a network device according to an embodiment of this application. A DU is connected to power amplifiers (power amplifiers, PAs) in a radio frequency unit. The radio frequency unit may be an RU, and the radio frequency unit is connected to an antenna array by using a cable.

To facilitate understanding of embodiments of this application, concepts in embodiments of this application are first described.

A beamforming (beamforming) technology is also referred to as beamforming or spatial domain filtering, and is a signal processing technology for directional signal sending and/or receiving through an array. The beamforming technology may be applied to both a signal transmitter and a signal receiver. In the beamforming technology, a parameter of a basic unit of a phase array is adjusted, so that signals at some angles are constructively interfered while signals at some other angles are destructively interfered, thereby generating a beam. In a multiple-input multiple-output (multiple-input multiple-output, MIMO) system, beamforming can improve quality of a received signal and increase the system throughput. The beamforming technology may be classified into a digital beamforming technology and an analog beamforming technology based on different positions at which beamforming is performed in a signal path.

An equally spaced beamforming antenna array includes a plurality of antenna subarrays, and each antenna subarray includes at least one antenna element. The antenna subarrays are equally spaced, and different antenna subarrays are of a symmetrical structure with respect to a column center. An antenna subarray close to a column center line is referred to as a middle column, and an antenna subarray far away from the column center line is referred to as a side column. In a possible manner of dividing a side column and a middle column, a midpoint between a center point of the antenna array and an antenna edge is taken, an antenna subarray between the midpoint and the center point of the antenna array is the middle column, and an antenna subarray between the midpoint and the antenna edge is the side column. FIG. 2 is a diagram of an equally spaced beamforming antenna array. For example, each antenna subarray includes two antenna elements.

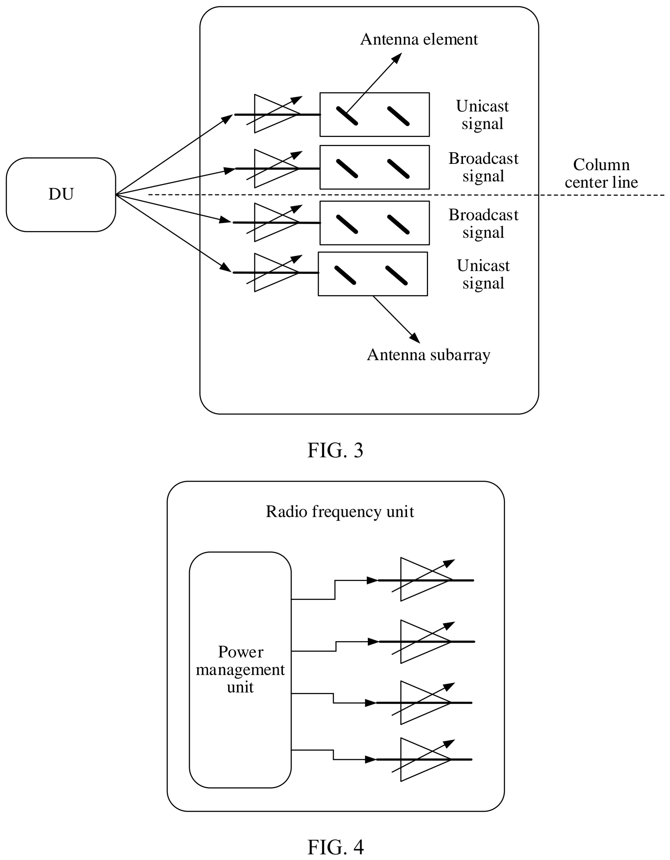

A heterogeneous signal sending antenna array includes a plurality of antenna subarrays, and each antenna subarray includes at least one antenna element. The antenna subarrays are equally spaced, and different antenna subarrays are of a symmetrical structure with respect to a column center. Different types of signals are sent by different antenna subarrays. FIG. 3 is a diagram of a heterogeneous signal sending antenna array. For example, a type of signals sent by two antenna subarrays in the middle is broadcast signal, and a type of signals sent by the other two antenna subarrays is unicast signal.

To facilitate understanding of embodiments of this application, the following briefly describes technical solutions related to embodiments of this application.

A multi-antenna system has become one of main means for improving communication performance at present and in the future. In the multi-antenna system, a base station needs to send a plurality of data streams to a plurality of radio frequency channels of a radio frequency unit. Generally, one radio frequency channel includes one power amplifier. The power amplifier amplifies a signal of a data stream to be at a sufficient power and then sends the signal via an antenna, to ensure that the signal meets coverage and other performance indexes. Therefore, the power amplifier is an important component in a wireless communication system, and correspondingly, efficiency improvement of the power amplifier is always a research hotspot.

As a frequency band of the wireless communication system becomes wider, there are more corresponding frequency bands. In the multi-antenna system, a quantity of channels of the radio frequency unit increases. In this case, a quantity of independent power amplifiers in one radio frequency unit increases, and a quantity of frequency bands supported by one power amplifier increases. Further, different power amplifiers have different power requirements, or power requirements of a plurality of frequency bands supported by one power amplifier are different. Therefore, power sharing between a plurality of power amplifiers or power sharing between a plurality of frequency bands in one power amplifier becomes an effective means for improving efficiency of a power amplifier.

A main principle of a solution of power sharing between a plurality of frequency bands in a single power amplifier is to dynamically allocate powers to different frequency bands based on different power requirements corresponding to actual services in different frequency bands. A specific implementation process includes: A power allocation control unit analyzes a power requirement corresponding to a real-time service of each frequency band, where one power amplifier supports both a frequency band 1 and a frequency band 2; and the power allocation control unit shares a redundant power of the frequency band 1 to the frequency band 2 having an additional power requirement. In this solution, only power sharing inside one power amplifier can be implemented, and a power of the power amplifier cannot be shared with another power amplifier.

A main principle of a solution of power sharing between a plurality of power amplifiers based on a bridge is to send same data by using a plurality of power amplifiers, so that an equivalent power for sending one piece of data exceeds a nominal power of one power amplifier, to achieve power sharing between the power amplifiers. The nominal power is an average maximum output power of all power amplifiers in the radio frequency unit. In addition, the nominal power may also be referred to as a rated power. This is not limited in this application.

For power sharing between a plurality of power amplifiers based on a bridge, new hardware circuits such as a digital bridge and an analog bridge need to be added to the radio frequency unit. As a result, an additional insertion loss is introduced, and an additional power loss is increased. In addition, leakage interference between different power amplifiers is prone to occur due to introduction of the digital bridge and the analog bridge.

In view of this, embodiments of this application provide a power sharing method, to implement power sharing between different power amplifiers, avoid an additional power loss, and reduce leakage interference between different power amplifiers.

FIG. 4 is a diagram of an apparatus applicable to a power sharing method in this application. For a radio frequency unit in the figure, refer to the foregoing descriptions of the RU. As shown in FIG. 4, the RU includes a plurality of different power amplifiers, and different power amplifiers may correspond to different radio frequency channels. For example, the RU includes a first power amplifier and a second power amplifier, and the first power amplifier and the second power amplifier correspond to different radio frequency channels. In a possible implementation, the RU may include a power management unit. It should be understood that the power management unit may alternatively be located in an apparatus or unit other than the RU, for example, a DU, a CU, or another apparatus. This is not limited in this application.

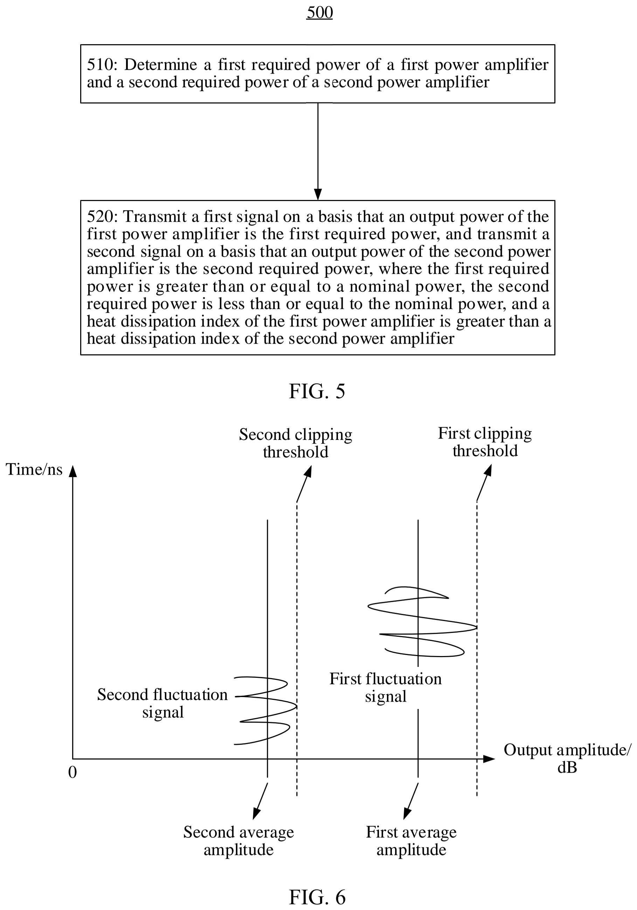

FIG. 5 is a schematic flowchart of a power sharing method according to this application. The method may include the following steps.

510: Determine a first required power of a first power amplifier and a second required power of a second power amplifier.

This step may be performed by an RU, or may be performed by a power management unit. The power management unit may be located in the RU, or may be a unit disposed independent of the RU. This is not limited in this application.

For example, this step is performed by the power management unit.

In a possible implementation, the power management unit may determine the first required power of the first power amplifier based on a position at which a first antenna subarray corresponding to the first power amplifier is located in an antenna array. The power management unit may determine the second required power of the second power amplifier based on a position at which a second antenna subarray corresponding to the second power amplifier is located in the antenna array. For example, the antenna array is an equally spaced beamforming antenna array. In an equally spaced beamforming antenna array, a required power of a power amplifier connected to an antenna subarray located in a middle column of the antenna array is high, and may be greater than a nominal power; and a required power of a power amplifier connected to an antenna subarray located in a side column of the antenna array is low, and may be less than the nominal power. The nominal power is an average maximum output power of all power amplifiers in a radio frequency unit, and different power amplifiers in the radio frequency unit has a same nominal power. For example, when a service volume is greater than a threshold, the required power of the power amplifier connected to the antenna subarray located in the middle column of the antenna array is greater than the nominal power.

It may be understood that the first required power is a required output power of the first power amplifier, which is similar for the second required power. Details are not described again.

In a possible implementation, the power management unit may determine the first required power of the first power amplifier based on a type of a first signal sent by the first antenna subarray corresponding to the first power amplifier. The power management unit may determine the second required power of the second power amplifier based on a type of a second signal sent by the second antenna subarray corresponding to the second power amplifier. In a heterogeneous signal sending antenna array, a required power of a power amplifier connected to an antenna subarray depends on a type of a signal sent by the antenna subarray. The type of the signal sent by the antenna subarray includes a broadcast signal, a unicast signal, a multicast signal, a signal of another specific type, or the like. This is not specifically limited in embodiments of this application. The broadcast signal needs to be sent to a plurality of users, the unicast signal needs to be sent to a single user, and the multicast signal needs to be sent to some of a plurality of users. Generally, a required power of a power amplifier connected to an antenna subarray sending a broadcast signal is high, and may be greater than the nominal power; and a required power of a power amplifier connected to an antenna subarray sending a unicast signal is low, and may be less than the nominal power.

In a possible implementation, the power management unit may determine the first required power of the first power amplifier based on the position at which the first antenna subarray corresponding to the first power amplifier is located in the antenna array and the type of the first signal sent by the first antenna subarray. The power management unit may determine the second required power of the second power amplifier based on the position at which the second antenna subarray corresponding to the second power amplifier is located in the antenna array and the type of the second signal sent by the second antenna subarray. A type of a signal sent by an antenna subarray may be related to a position at which the antenna subarray is located in the antenna array. For example, the antenna subarray located in the middle column of the antenna array may send a broadcast signal or a multicast signal, and the antenna subarray located in the side column of the antenna array may send a unicast signal.

520: Transmit the first signal on a basis that an output power of the first power amplifier is the first required power, and transmit the second signal on a basis that an output power of the second power amplifier is the second required power, where the first required power of the first power amplifier is greater than or equal to the nominal power, the second required power of the second power amplifier is less than or equal to the nominal power, and a heat dissipation index of the first power amplifier is greater than a heat dissipation index of the second power amplifier.

This step may be performed by the RU.

A heat dissipation index in this application may be understood as a heat dissipation capability, or may be understood as a rated value of allowed maximum heat dissipation. The rated value of the allowed maximum heat dissipation may be heat dissipation when a power amplifier operates at the nominal power. In a possible case, the rated value of the allowed maximum heat dissipation may be average heat dissipation per unit time within a measurement time period. A higher required power of the power amplifier indicates a higher requirement on a heat dissipation capability of the power amplifier.

It may be understood that, because the first required power of the first power amplifier is greater than the nominal power, and the second required power of the second power amplifier is less than the nominal power, the output power of the first power amplifier is greater than the output power of the second power amplifier.

That the heat dissipation index of the first power amplifier is greater than the heat dissipation index of the second power amplifier may be understood as that a heat dissipation capability of the first power amplifier is greater than a heat dissipation capability of the second power amplifier, where the heat dissipation capability is maximum heat dissipation that can be borne by the power amplifier; or may be understood as that a heat dissipation capability of the first power amplifier is greater than a heat dissipation capability of the second power amplifier, and allowed maximum heat dissipation of the first power amplifier is greater than allowed maximum heat dissipation of the second power amplifier; or may be understood as that allowed maximum heat dissipation of the first power amplifier is greater than allowed maximum heat dissipation of the second power amplifier.

For example, in the equally spaced beamforming antenna array, the first antenna subarray corresponding to the first power amplifier is located in a middle column of the antenna array, and the second antenna subarray corresponding to the second power amplifier is located in a side column of the antenna array; and it is determined that the first required power of the first power amplifier is greater than or equal to the nominal power, and the second required power of the second power amplifier is greater than or equal to the nominal power.

For example, in the heterogeneous signal sending antenna array, the type of the first signal sent by the first antenna subarray corresponding to the first power amplifier is a broadcast signal, and the type of the second signal sent by the second antenna subarray corresponding to the second power amplifier is a unicast signal; and it is determined that the first required power of the first power amplifier is greater than or equal to the nominal power, and the second required power of the second power amplifier is greater than or equal to the nominal power.

For example, the first antenna subarray corresponding to the first power amplifier is located in the middle column of the antenna array, and the type of the first signal sent by the first antenna subarray is a broadcast signal; the second antenna subarray corresponding to the second power amplifier is located in the side column of the antenna array, and the type of the second signal sent by the second antenna subarray is a unicast signal; and it is determined that the first required power of the first power amplifier is greater than or equal to the nominal power, and the second required power of the second power amplifier is greater than or equal to the nominal power.

In a possible implementation, a sum of the first required power of the first power amplifier and the second required power of the second power amplifier is less than or equal to twice the nominal power. The method can prevent a total required power of the first power amplifier and the second power amplifier from being excessively high, to ensure safety of the radio frequency unit.

In a possible implementation, the first required power is less than or equal to a first threshold, and the first threshold is a maximum output power of the first power amplifier. The first threshold may also be understood as an allowed maximum output power of the first power amplifier. Specifically, the first required power of the first power amplifier is greater than the nominal power and less than or equal to the first threshold. For example, the first threshold may be 1.2 to 1.3 times the nominal power. If the first required power of the first power amplifier exceeds the allowed maximum output power of the first power amplifier, the first power amplifier may be damaged. Therefore, the solution provided in this implementation can avoid damage to the first power amplifier.

In a possible implementation, a sum of a heat dissipation requirement with the output power of the first power amplifier being the first required power and a heat dissipation requirement with the output power of the second power amplifier being the second required power is less than or equal to a second threshold. The second threshold is a total heat dissipation requirement with the output power of the first power amplifier and the output power of the second power amplifier each being the nominal power. The second threshold may be understood as maximum total heat dissipation when the output power of the first power amplifier and the output power of the second power amplifier each are the nominal power.

The sum of the heat dissipation requirement with the output power of the first power amplifier being the first required power and the heat dissipation requirement with the output power of the second power amplifier being the second required power is less than or equal to the second threshold, so that it can be ensured that heat dissipation of the entire radio frequency unit is maintained within a safe range, to ensure safety of the radio frequency unit.

For example, the allowed maximum heat dissipation $Therma_H$ when the output power of the first power amplifier is the first required power, the allowed maximum heat dissipation $Therma_L$ when the output power of the second power amplifier is the second required power, and the total heat dissipation requirement/the maximum total heat dissipation $Therma_T$, namely, the second threshold, when the output power of the first power amplifier and the output power of the second power amplifier each are the nominal power satisfy the following formula (1):

$$Therma_H + Therma_L \leq Therma_T \qquad (1)$$

For example, the heat dissipation index of the first power amplifier is less than or equal to a third threshold, and the third threshold is actual allowed maximum heat dissipation of the first power amplifier. When heat generated when the first power amplifier transmits a signal at a specific power exceeds the third threshold, the first power amplifier is burnt out. Specifically, the heat dissipation index of the first power amplifier is greater than the heat dissipation index of the second power amplifier and less than the third threshold, so that the heat dissipation index of the first power amplifier can be prevented from being excessively large, to ensure that the heat dissipation of the entire radio frequency unit is maintained within a safe range, so as to ensure safety of the radio frequency unit.

In the technical solution provided in embodiments of this application, the second required power of the second power amplifier is low, and a heat dissipation index when the output power of the second power amplifier is the second required power is redundant relative to a heat dissipation index when the output power of the second power amplifier is the nominal power. However, the first required power of the first power amplifier is high, and a heat dissipation index when the output power of the first power amplifier is the first required power is insufficient relative to a heat dissipation index when the output power of the first power amplifier is the nominal power. The technical solution in embodiments of this application is equivalent to that the first power amplifier borrows the heat dissipation index of the second power amplifier, so that it can be ensured that the heat dissipation of the entire radio frequency unit is maintained within a safe range. Therefore, in embodiments of this application, heat dissipation indexes are shared between different power amplifiers, so that power sharing between different power amplifiers is equivalently implemented.

In a possible implementation, a clipping threshold corresponding to the first power amplifier is greater than a clipping threshold corresponding to the second power amplifier. The clipping threshold is used to limit an amplitude of a signal that exceeds the clipping threshold in a fluctuation signal, to ensure that a maximum amplitude of the fluctuation signal does not exceed the clipping threshold. The fluctuation signal is a signal whose signal amplitude changes with time. Because the clipping threshold corresponding to the first power amplifier is greater than the clipping threshold corresponding to the second power amplifier, when the output power of the first power amplifier is greater than the output power of the second power amplifier, a design of the clipping threshold can prevent an error vector magnitude EVM of an output signal of the first power amplifier from being excessively large, to avoid distortion of the output signal of the first power amplifier. FIG. 6 is a diagram of a first clipping threshold corresponding to a first power amplifier and a second clipping threshold corresponding to a second power amplifier. A horizontal coordinate represents an output amplitude of a fluctuation signal, in a unit of dB; and a vertical coordinate represents time, in a unit of ns. The first power amplifier performs clipping on a first fluctuation signal by using the first clipping threshold, where an average amplitude of the first fluctuation signal is a first average amplitude. The second power amplifier performs clipping on a second fluctuation signal by using the second clipping threshold, where an average amplitude of the second fluctuation signal is a second average amplitude.

In the existing technical solution, nominal powers of different power amplifiers corresponding to different radio frequency channels are the same, and clipping thresholds corresponding to different power amplifiers are also the same. In the power sharing method provided in embodiments of this application, the output power of the first power amplifier is greater than the output power of the second power amplifier, and an instantaneous power Pist of a fluctuation signal output by the first power amplifier satisfy Pist=Pavg+PAPR, where Pavg represents the nominal power, and PAPR represents a fluctuation degree of a "peak power" of the fluctuation signal relative to an average power of the fluctuation signal. When an average output power of the first power amplifier is greater than the nominal power, the instantaneous power of the fluctuation signal output by the first power amplifier is significantly increased. If the fluctuation signal is processed based on the clipping threshold in the existing technical solution, the EVM of the output fluctuation signal is significantly increased, and consequently, the output signal of the first power amplifier is seriously distorted. Therefore, in the technical solution provided in embodiments of this application, the clipping threshold corresponding to the first power amplifier is adjusted, so that the clipping threshold corresponding to the first power amplifier is greater than the clipping threshold corresponding to the second power amplifier, to avoid distortion of the output signal of the first power amplifier.

The foregoing describes the power sharing method provided in embodiments of this application, and the following describes an execution entity for performing the foregoing power sharing method.

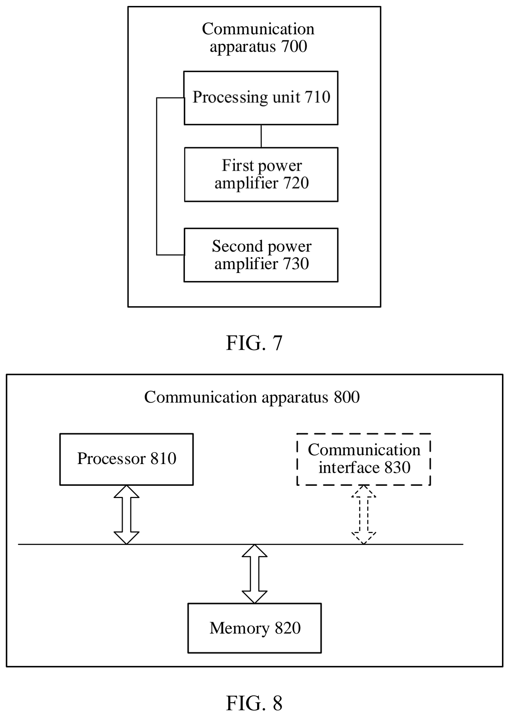

FIG. 7 is a block diagram of a communication apparatus 700 according to an embodiment of this application. The apparatus may be used in a network device/radio frequency unit in embodiments of this application. The communication apparatus 700 includes a processing unit 710, a first power amplifier 720, and a second power amplifier 730. The first power amplifier 720 and the second power amplifier 730 correspond to different radio frequency channels.

The processing unit 710 is configured to determine a first required power of the first power amplifier and a second required power of the second power amplifier.

The processing unit 710 is further configured to transmit a first signal on a basis that an output power of the first power amplifier is the first required power, and transmit a second signal on a basis that an output power of the second power amplifier is the second required power, where the first required power is greater than or equal to a nominal power, the second required power is less than or equal to the nominal power, and a heat dissipation index of the first power amplifier is greater than a heat dissipation index of the second power amplifier, where the nominal power is an average maximum output power of all power amplifiers in the communication apparatus. For example, the processing unit 710 is the foregoing power management unit.

In a possible implementation, the processing unit 710 is specifically configured to: determine the first required power based on a position at which a first antenna subarray corresponding to the first power amplifier is located in an antenna array, where the antenna array is an equally spaced beamforming antenna array; and determine the second required power based on a position at which a second antenna subarray corresponding to the second power amplifier is located in the antenna array.

In a possible implementation, the position at which the first antenna subarray is located in the antenna array is a middle column of the antenna array, and the position at which the second antenna subarray is located in the antenna array is a side column of the antenna array.

In a possible implementation, the processing unit 710 is specifically configured to: determine the first required power based on a type of the first signal; and determine the second required power based on a type of the second signal.

In a possible implementation, the type of the first signal is a broadcast signal, and the type of the second signal is a unicast signal.

In a possible implementation, a clipping threshold corresponding to the first power amplifier is greater than a clipping threshold corresponding to the second power amplifier.

In a possible implementation, a sum of the first required power and the second required power is less than or equal to twice the nominal power.

In a possible implementation, the first required power is less than or equal to a first threshold, and the first threshold is a maximum output power of the first power amplifier.

In a possible implementation, a sum of a heat dissipation requirement with the output power of the first power amplifier being the first required power and a heat dissipation requirement with the output power of the second power amplifier being the second required power is less than or equal to a second threshold, and the second threshold is a total heat dissipation requirement with the output power of the first power amplifier and the output power of the second power amplifier each being the nominal power.

In a possible implementation, the heat dissipation index of the first power amplifier is less than or equal to a third threshold, and the third threshold is allowed maximum heat dissipation of the first power amplifier.

FIG. 8 is a block diagram of a communication apparatus 800 according to an embodiment of this application. The communication apparatus 800 includes a processor 810, a memory 820, and a communication interface 830.

The memory 820 is configured to store executable instructions.

The processor 810 is coupled to the memory 820 through the communication interface 830. The processor 810 is configured to invoke and run the executable instructions in the memory 820, to implement the methods in embodiments of this application. The communication apparatus may be used in a network device/radio frequency unit in embodiments of this application. In a possible implementation, the processor 810 and the memory 820 are integrated together.

The processor 810 may be an integrated circuit chip, and has a signal processing capability. In an implementation process, steps in the foregoing method embodiments can be implemented by using an integrated logic circuit of hardware in the processor, or by using instructions in a form of software. The foregoing processor may be a general-purpose processor, a digital signal processor (digital signal processor, DSP), an application-specific integrated circuit (application specific integrated circuit, ASIC), a field programmable gate array (field programmable gate array, FPGA) or another programmable logic device, a discrete gate or transistor logical device, or a discrete hardware component. It may implement or perform the methods, the steps, and logical block diagrams that are disclosed in embodiments of this application. The general-purpose processor may be a microprocessor, or the processor may be any conventional processor or the like. The steps in the methods disclosed with reference to embodiments of this application may be directly performed and completed by a hardware decoding processor, or may be performed and completed by using a combination of hardware in the decoding processor and a software module. A software module may be located in a mature storage medium in the art, for example, a random access memory, a flash memory, a read-only memory, a programmable read-only memory, an electrically erasable programmable memory, or a register. The storage medium is located in a memory, and the processor reads information in the memory and completes the steps in the foregoing methods in combination with hardware of the processor.

In a possible implementation, an embodiment of this application further provides a communication apparatus. The communication apparatus includes units for performing the method in the foregoing method embodiments.

In a possible implementation, an embodiment of this application further provides a communication apparatus. The communication apparatus includes an input/output interface and a logic circuit. The input/output interface is configured to obtain input information and/or output information. The logic circuit is configured to perform the method in the foregoing method embodiments, and perform processing and/or generate output information based on the input information.

An embodiment of this application further provides a computer-readable storage medium. The computer-readable storage medium stores a computer program used to implement the method in the foregoing method embodiments. When the computer program is run on a computer, the computer is caused to implement the method in the foregoing method embodiments.

An embodiment of this application further provides a computer program product. The computer program product includes computer program code. When the computer program code is run on a computer, the method in the foregoing method embodiments is performed.

An embodiment of this application further provides a chip, including a processor. The processor is connected to a memory, and the memory is configured to store a computer program. The processor is configured to execute the computer program stored in the memory, so that the chip performs the method in the foregoing method embodiments.

It should be understood that in embodiments of this application, numbers "first", "second", and the like are merely for distinguishing between different objects, for example, for distinguishing between different power amplifiers or different thresholds, and do not constitute a limitation on the scope of embodiments of this application. Embodiments of this application are not limited thereto.

In addition, the term "and/or" in this application describes only an association relationship between associated objects, and indicates that three relationships may exist. For example, A and/or B may indicate the following three cases: only A exists; both A and B exist; or only B exists. In addition, the character "/" in this specification generally represents an "or" relationship between associated objects. In this application, the term "at least one" may indicate "one" and "two or more". For example, at least one of A, B, and C may indicate the following seven cases: only A exists, only B exists, only C exists, both A and B exist, both A and C exist, and both C and B exist, and A, B, C all exist.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for detailed working processes of the foregoing systems, apparatuses, and units, reference may be made to corresponding processes in the foregoing method embodiments. Details are not described herein again.

In the several embodiments provided in this application, it should be understood that the disclosed system, apparatus, and method may be implemented in other manners. For example, the described apparatus embodiments are merely examples. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the current technology, or some of the technical solutions may be implemented in a form of a software product. The computer software product is stored in a storage medium, and includes several instructions for indicating a computer device (which may be a personal computer, a server, or a network device) to perform all or a part of the steps of the methods described in embodiments of this application. The foregoing storage medium includes any medium that can store program code, for example, a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power sharing method, wherein a radio frequency unit comprises a first power amplifier and a second power amplifier, the first power amplifier and the second power amplifier correspond to different radio frequency channels, and the method comprises:

   determining a first required power of the first power amplifier and a second required power of the second power amplifier; and
   transmitting a first signal on a basis that an output power of the first power amplifier is the first required power, and transmitting a second signal on a basis that an output power of the second power amplifier is the second required power, wherein the first required power is greater than or equal to a nominal power, the second required power is less than or equal to the nominal power, and a heat dissipation index of the first power amplifier is greater than a heat dissipation index of the second power amplifier, wherein the nominal power is an average maximum output power of all power amplifiers in the radio frequency unit.

2. The method according to claim 1, wherein determining the first required power of the first power amplifier and the second required power of the second power amplifier comprises:

   determining the first required power based on a position at which a first antenna subarray corresponding to the first power amplifier is located in an antenna array, wherein the antenna array is an equally spaced beamforming antenna array; and
   determining the second required power based on a position at which a second antenna subarray corresponding to the second power amplifier is located in the antenna array.

3. The method according to claim 2, wherein the position at which the first antenna subarray is located in the antenna array is a middle column of the antenna array, and the position at which the second antenna subarray is located in the antenna array is a side column of the antenna array.

4. The method according to any one of claims 1 to 3, wherein determining the first required power of the first power amplifier and the second required power of the second power amplifier comprises:

   determining the first required power based on a type of the first signal; and
   determining the second required power based on a type of the second signal.

5. The method according to claim 4, wherein the type of the first signal is a broadcast signal, and the type of the second signal is a unicast signal.

6. The method according to any one of claims 1 to 5, wherein a clipping threshold corresponding to the first power amplifier is greater than a clipping threshold corresponding to the second power amplifier.

7. The method according to any one of claims 1 to 6, wherein a sum of the first required power and the second required power is less than or equal to twice the nominal power.

8. The method according to any one of claims 1 to 7, wherein the first required power is less than or equal to a first threshold, and the first threshold is a maximum output power of the first power amplifier.

9. The method according to any one of claims 1 to 8, wherein a sum of a heat dissipation requirement with the output power of the first power amplifier being the first required power and a heat dissipation requirement with the output power of the second power amplifier being the second required power is less than or equal to a second threshold, and the second threshold is a total heat dissipation requirement with the output power of the first power amplifier and the output power of the second power amplifier each being the nominal power.

10. The method according to any one of claims 1 to 9, wherein the heat dissipation index of the first power amplifier is less than or equal to a third threshold, and the third threshold is allowed maximum heat dissipation of the first power amplifier.

11. A communication apparatus, wherein the communication apparatus comprises a processing unit, a first power amplifier, and a second power amplifier, and the first power amplifier and the second power amplifier correspond to different radio frequency channels;

   the processing unit is configured to determine a first required power of the first power amplifier and a second required power of the second power amplifier; and
   the processing unit is further configured to transmit a first signal on a basis that an output power of the first power amplifier is the first required power, and transmit a second signal on a basis that an output power of the second power amplifier is the second required power, wherein the first required power is greater than or equal to a nominal power, the second required power is less than or equal to the nominal power, and a heat dissipation index of the first power amplifier is greater than a heat dissipation index of the second power amplifier, wherein the nominal power is an average maximum output power of all power amplifiers in the communication apparatus.

12. The apparatus according to claim 11, wherein the processing unit is specifically configured to:

   determine the first required power based on a position at which a first antenna subarray corresponding to the first power amplifier is located in an antenna array, wherein the antenna array is an equally spaced beamforming antenna array; and
   determine the second required power based on a position at which a second antenna subarray corresponding to the second power amplifier is located in the antenna array.

13. The apparatus according to claim 12, wherein the position at which the first antenna subarray is located in the antenna array is a middle column of the antenna array, and the position at which the second antenna subarray is located in the antenna array is a side column of the antenna array.

14. The apparatus according to any one of claims 11 to 13, wherein the processing unit is specifically configured to:

determine the first required power based on a type of the first signal; and
determine the second required power based on a type of the second signal.

15. The apparatus according to claim 14, wherein the type of the first signal is a broadcast signal, and the type of the second signal is a unicast signal.

16. The apparatus according to any one of claims 11 to 15, wherein a clipping threshold corresponding to the first power amplifier is greater than a clipping threshold corresponding to the second power amplifier.

17. The apparatus according to any one of claims 11 to 16, wherein a sum of the first required power and the second required power is less than or equal to twice the nominal power.

18. The apparatus according to any one of claims 11 to 17, wherein the first required power is less than or equal to a first threshold, and the first threshold is a maximum output power of the first power amplifier.

19. The apparatus according to any one of claims 11 to 18, wherein a sum of a heat dissipation requirement with the output power of the first power amplifier being the first required power and a heat dissipation requirement with the output power of the second power amplifier being the second required power is less than or equal to a second threshold, and the second threshold is a total heat dissipation requirement with the output power of the first power amplifier and the output power of the second power amplifier each being the nominal power.

20. The apparatus according to any one of claims 11 to 19, wherein the heat dissipation index of the first power amplifier is less than or equal to a third threshold, and the third threshold is allowed maximum heat dissipation of the first power amplifier.

21. The apparatus according to any one of claims 11 to 20, wherein the processing unit comprises a power management unit.

22. A communication apparatus, comprising a unit configured to perform the method according to any one of claims 1 to 10.

23. A computer-readable storage medium, wherein

the computer-readable medium stores a computer program; and
when the computer program is run on a computer, the computer is caused to perform the method according to any one of claims 1 to 10.

24. A computer program product, comprising a computer program, wherein when the computer program is executed, the method according to any one of claims 1 to 10 is implemented.

25. A system, comprising at least one communication apparatus, wherein the communication apparatus is configured to perform the method according to any one of claims 1 to 10.

FIG. 1

FIG. 2

FIG. 3

FIG. 4

500

510: Determine a first required power of a first power amplifier and a second required power of a second power amplifier

520: Transmit a first signal on a basis that an output power of the first power amplifier is the first required power, and transmit a second signal on a basis that an output power of the second power amplifier is the second required power, where the first required power is greater than or equal to a nominal power, the second required power is less than or equal to the nominal power, and a heat dissipation index of the first power amplifier is greater than a heat dissipation index of the second power amplifier

FIG. 5

Second clipping threshold

First clipping threshold

Time/ns

First fluctuation signal

Second fluctuation signal

Output amplitude/ dB

0

Second average amplitude

First average amplitude

FIG. 6

Communication
apparatus 700

Processing unit 710

First power
amplifier 720

Second power
amplifier 730

FIG. 7

Communication apparatus 800

Processor 810

Communication
interface 830

Memory 820

FIG. 8

## INTERNATIONAL SEARCH REPORT

| | International application No. |
|---|---|
| | **PCT/CN2024/101562** |

| **A.** | **CLASSIFICATION OF SUBJECT MATTER** |
|---|---|

H04B1/04(2006.01)i

According to International Patent Classification (IPC) or to both national classification and IPC

| **B.** | **FIELDS SEARCHED** |
|---|---|

Minimum documentation searched (classification system followed by classification symbols)

IPC:H04B1/-、H03F1/-、H03F3/-

Documentation searched other than minimum documentation to the extent that such documents are included in the fields searched

Electronic data base consulted during the international search (name of data base and, where practicable, search terms used)

CNTXT; WPABSC; ENTXTC; CNKI: 第二, 第一, 多, 功率, 功率放大器, 共享, 均衡, 量, 能力, 散热, 指标; WPABS; ENTXT; DWPI; 3GPP; IEEE: first, second, multi, power, heat, shar+, balanc+, power amplifier?

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| Y | US 11605887 B1 (AMAZON TECHNOLOGIES, INC.) 14 March 2023 (2023-03-14) description, column 7, line 63-column 22, line 64 | 1-25 |
| Y | CN 214959529 U (MURATA MANUFACTURING CO., LTD.) 30 November 2021 (2021-11-30) description, paragraphs [0115]-[0128], and figure 3A | 1-25 |
| A | CN 105680801 A (HEFEI LEICHENG MICROELECTRONICS CO., LTD.) 15 June 2016 (2016-06-15) entire document | 1-25 |
| A | CN 112968679 A (RADROCK (SHENZHEN) TECHNOLOGY CO., LTD.) 15 June 2021 (2021-06-15) entire document | 1-25 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **06 August 2024** | **08 August 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**EP 4 727 020 A1**

| INTERNATIONAL SEARCH REPORT | International application No. |
| Information on patent family members | **PCT/CN2024/101562** |

| Patent document cited in search report | | | Publication date (day/month/year) | Patent family member(s) | | | Publication date (day/month/year) |
|---|---|---|---|---|---|---|---|
| US | 11605887 | B1 | 14 March 2023 | None | | | |
| CN | 214959529 | U | 30 November 2021 | US | 2021336647 | A1 | 28 October 2021 |
| | | | | US | 11394421 | B2 | 19 July 2022 |
| | | | | JP | 2021174854 | A | 01 November 2021 |
| | | | | KR | 20210131235 | A | 02 November 2021 |
| | | | | KR | 102575255 | B1 | 06 September 2023 |
| CN | 105680801 | A | 15 June 2016 | CN | 105680801 | B | 15 June 2018 |
| CN | 112968679 | A | 15 June 2021 | WO | 2022166652 | A1 | 11 August 2022 |
| | | | | CN | 112968679 | B | 19 September 2023 |

Form PCT/ISA/210 (patent family annex) (July 2022)